# EUROPEAN PATENT SPECIFICATION

(11) **EP 1 804 306 B1**
(45) Date of publication and mention of the grant of the patent: **28.07.2010**
(21) Application number: 05113039.1
(22) Date of filing: 28.12.2005
(51) Int. Cl.: H01L 39/24, C23C 14/56, F16J 15/16

(54) **Plant for the production in continuous of a superconducting tape**
Anlage zur kontinuierlichen Herstellung eines Supraleiterbandes
Installation pour la production en continu d'une bande supraconductrice

(43) Date of publication of application: 04.07.2007
(73) Proprietor: Rial Vacuum S.R.L., 43100 Parma (IT)
(72) Inventor: Canetti, Marco, 43100, Parma (IT); Battocchio, Alessandro, 20090, Rodano (Milano) (IT)
(74) Representative: De Gregori, Antonella

(56) References cited:
- EP-A- 0 305 573
- WO-A-2004/012278
- FR-A- 1 545 284
- GB-A- 766 459

## Description

The present invention relates to a plant for the production in continuous of a superconducting tape and a relative surface treatment process.

Flexible superconducting tapes, commonly called "coated conductors", consist of a flexible metallic tape which acts as a mechanical support and on which a thin layer of ceramic superconducting material is deposited, for example Ba₂Cu₃Oₓ, of the so-called "RareEarth" type, by the interpositioning of various intermediate barrier layers which facilitate the adhesion of the superconducting layer to the metallic substrate.

Superconducting tapes are semi-processed products which, if produced in industrially interesting lengths and quantities, can be used as current conductors in most devices of the electric type, once they have been appropriately cooled. They do, in fact, have current conductor properties approximately a thousand times higher than copper at the same temperature and form a possible solution for increasing energy requirement problems.

Production processes of superconducting elements which enhance the characteristics of uniformity and superconductive properties are vacuum deposition processes, which envisage various mixtures of oxidizing and reducing gases and different vacuum degrees. Various known technologies can be used for vacuum deposition, such as thermal evaporation or electronic bombardment, or other.

The main disadvantage of the vacuum deposition processes currently adopted, is linked to the use of single chamber vacuum systems. The elements to be coated are placed in sequence in successive chambers, in each of which one of the passages required for the production of superconductors is effected.

The high number of passages and their intrinsic duration prevent the present state of the art from producing superconductors having lengths of industrial interest, i.e. at least greater than 100 m, to allow the production of any electric device.

Furthermore, effecting the various passages in different and separate chambers and exposing the tape each time to the air when transferring it from one vacuum chamber to the next, has the drawback of surface pollution during the loading and unloading operations of the superconductor reels, which leads to a deterioration in the properties of the superconductive layer deposited.

GB 766,459 discloses an apparatus for continuously coating strip material comprising three mutually adjacent enclosures adapted to be tightly sealed against the outer atmosphere and interconnected by connecting members, two of the enclosures serving for the accommodation of the material supply and take-up rolls and glow-discharge cathodes for effecting preliminary and subsequent glow-discharge treatment of the tape material or of the applied coating while the third enclosure is adapted to be placed under high-vacuum and serves for the accommodation of the vapour deposition or cathode sputtering devices. The two kinds of enclosures are separated by a lock chamber system forming inlet and outlet sides for the strip material to pass into and away from a treatment area for the application of the coating, respectively, wherein each lock chamber system comprises at least two intermediate chambers with the pressure decreasing or increasing in steps, the partition wall of said lock chamber systems being provided with narrow slots serving for the passage of the strip material, said slots being adjustable in width from outside by at least one lip or edge formed by the partition wall, which is resiliently constructed and variable in height.

WO 2004/12278 A teaches a system for continuously forming a superconductor tape using a pay-out reel and take-up reel to respectively dispense and spool a tape substrate, a series of chambers to pretreat the substrate, to form buffer, superconductor and coating layers, and to post-treat the tape, wherein transition chambers are arranged between adjacent chambers to isolate them from each other.

An objective of the present invention is to provide a plant for the production in continuous of a superconducting tape which allows the production of superconducting tapes having an industrially interesting length.

A further objective of the present invention is to provide a plant for the production in continuous of a superconducting tape for the production of superconducting tapes with high properties of the superconductive layer deposited.

Another objective of the present invention is to provide a plant for the production in continuous of a superconducting tape which are particularly simple and functional with reduced costs.

These objectives, according to the present invention, are achieved by providing a plant for the production in continuous of a superconducting tape as specified in the independent claim.

Further characteristics are envisaged in the dependent claims.

The characteristics and advantages of a plant for the production in continuous of a superconducting tape andaccording to the present invention will appear more evident from the following illustrative and non-limiting example, referring to the enclosed schematic drawings, in which:
figure 1 is a raised side view of a plant for the production in continuous of a superconducting tape, according to the present invention;
figure 2 shows the plant of figure 1 in a sectional plan view according to a trace plane II-II;
figure 3 shows the plant for the production in continuous of a superconducting tape, according to the present invention, in a sectional view according to a trace plane III-III shown in figure 2;
figure 4 is a raised side view of a connection unit, object of the present invention;
figure 5 shows a plan view of the connection unit of figure 4 without the cover;
figure 6 shows the connection unit of figure 5 in a sectional view along a trace plane VI-VI;
figure 7 is a transversal section of figure 6 effected along a trace plane VII-VII;
figure 8 shows an enlarged detail of a transversal section of the connection unit of figure 4 according to a trace plane VIII-VIII.

With reference to the figures, these show a plant for the production in continuous of a superconducting tape, indicated as a whole with 10.

The plant 10, which continuously effects the multiphase surface treatment of a substrate consisting of a tape 12, comprises at least two controlled pressure chambers 13 arranged in series, in which the successive treatment phases take place. Each chamber 13 is marked by its own process conditions, i.e. by a different vacuum degree, with differences between the chambers of even five orders of magnitude, for example typically ranging from 10³ Pa to 10⁻² Pa, and a different atmosphere, i.e. mixture of treatment gas.

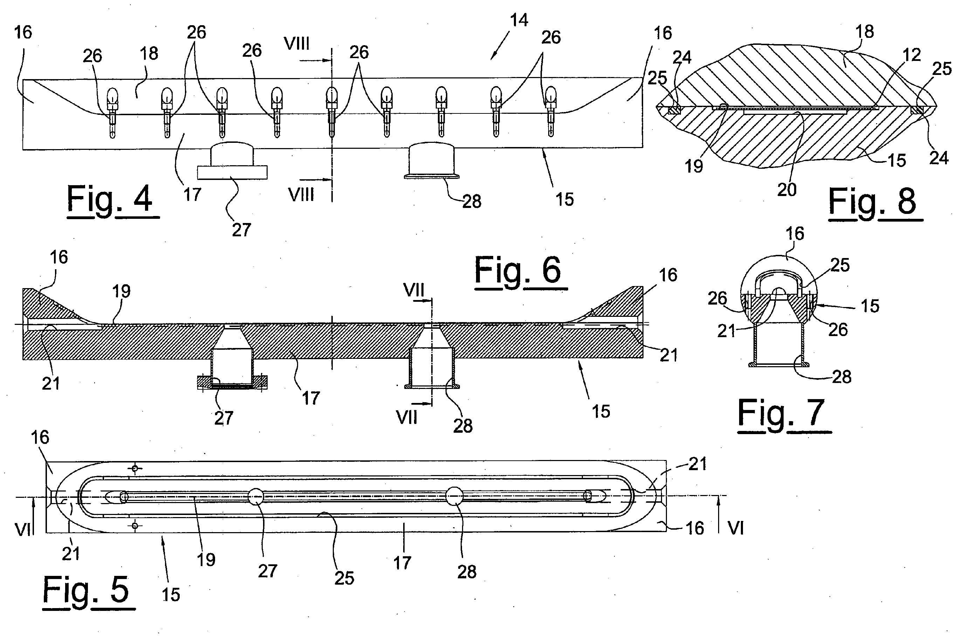

The chambers 13 are connected to each others by sealed connection units 14, shown in detail in figures 4 to 8, which allow the continuous passage, or running, of the tape 12, but preserve the atmosphere and pressure differences between the chambers 13.

The figures illustrate a preferred embodiment of the connection unit 14, according to the present invention, cylindrically shaped and connectable at its ends to the vacuum chambers 13 by means of flanges, not shown.

The connection unit 14 comprises a base 15 having cylindrical connection ends 16 and a central semi-cylindrical portion 17, for example made of stainless steel, and a substantially semi-cylindrical cover 18, for example made of aluminum, as shown in the raised view of figure 4.

On the surface facing the cover, the central portion 17 of the base comprises a longitudinal seat 19 for supporting and guiding the tape 12 (figure 5). As shown in the enlarged detail of figure 8, which illustrates a transversal section of the connection unit 14, the seat 19 has a height which is greater than the thickness of the tape 12 and comprises a central portion 20 with a greater grooving.

The seat 19 is connected at each end to a pass-through hole 21, shown in the section of figure 6, produced in the end portions 16 of the base 15 for the passage of the tape 12.

The tape 12 runs inside the connection unit 14 with a slight contact friction only on its sides and without rubbing against the walls of the duct, at least on the side on which it is being treated which is facing downwards.

The cover 18 is equipped with ends having the shape of a flute's mouthpiece, which are coupled with complementary tilting surfaces of the base 15. A sealing element 24, or O-ring, is situated in a closed-ring groove 25 positioned in the base 15, or alternatively on the cover, on opposite sides of the guiding seat 19 of the tape and on the tilting surfaces (figure 7). The sealing element 24 never interferes with the tape 12 and forms a sealing coupling between the base 15 and the cover 18, when they are closed tightly by means of bolts 26.

The connection unit 14 is long and narrow and maximizes the impedance to the gas flow between adjacent chambers.

The residual gas flow which, moved by the relative pressure differences at the ends of the connection unit 14, would pass through the connection unit from the chamber 13 having a higher pressure, towards the other chamber 13 with a lower pressure, is intercepted by at least one or more pumping devices connected to the connection unit 14.

The connection unit 14 preferably comprises a first connection 27 to a primary pumping device, or rotary vane pump, and a second connection 28 to a secondary pumping device, or turbomolecular pump, which intercept the gaseous streams at different pressures in two successive points.

A first primary pumping device, facing the higher pressure end, comprises a rotary vane pump with an operating pressure of about 10³ Pa. A secondary pumping device, facing the lower pressure end, comprises a turbomolecular pump, with operating pressures of about 10⁻² Pa, connected for the supply to the primary pump.

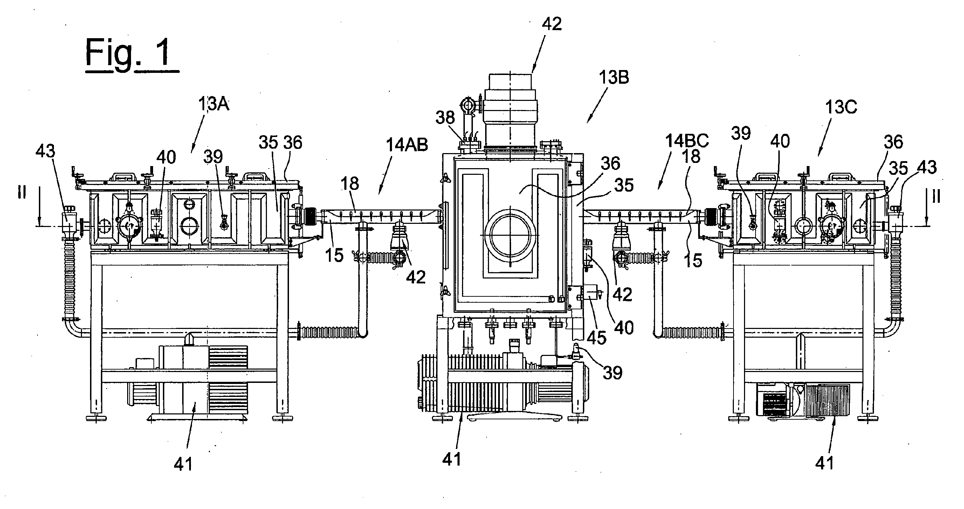

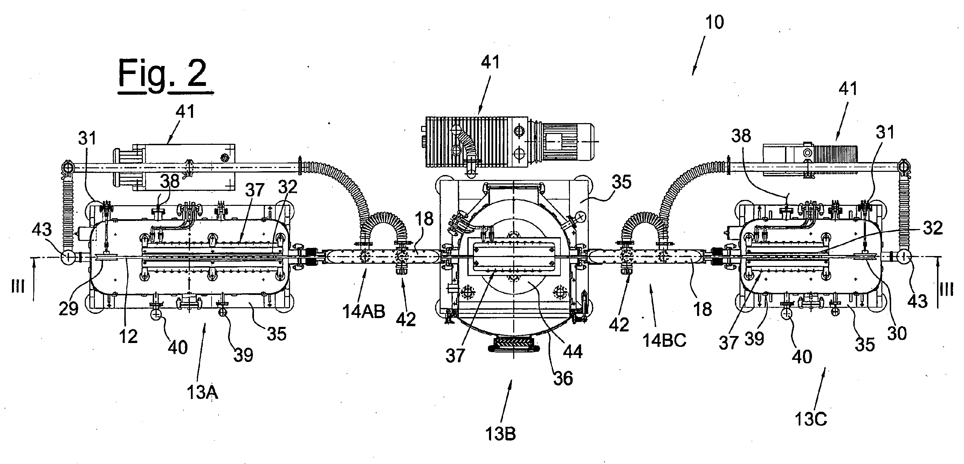

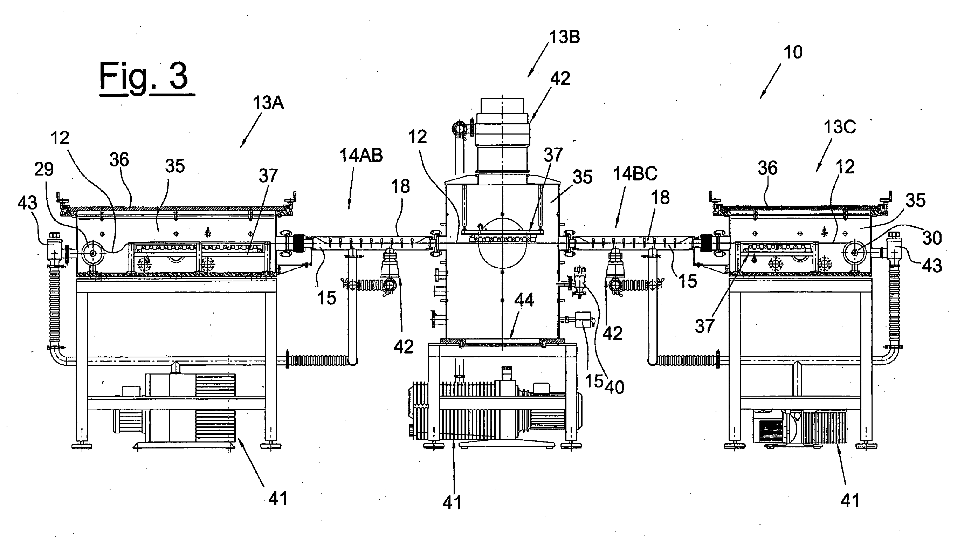

Figures 1 to 3 show an illustrative embodiment of a plant for the production in continuous of a superconducting tape 10 according to the present invention, which effects, for example, a typical surface pre-treatment sequence of the semi-processes metallic tape, the deposition of oxides, for example cerium oxide (CeO₂), and surface post-treatment.

The plant 10 comprises three vacuum chambers 13 arranged in series and connected to each other by two connection units 14, such as those described above. A first pre-treatment chamber 13A with a reducing atmosphere consisting of a mixture of argon and hydrogen and a pressure of 10³ Pa is connected by means of a first connection unit 14AB to a deposition chamber 13B with a reducing atmosphere consisting of a mixture of argon, hydrogen and oxygen and a pressure of 10⁻² Pa, also connected by means of a second connection unit 14BC to a post-treatment chamber 13C with an oxidizing atmosphere consisting of oxygen and a pressure of 10³ Pa.

The tape 12 is loaded into the pre-treatment chamber 13A wound on a feeding reel 29, and is re-wound in the post-treatment chamber 13C onto a second winding reel 30. Both reels are equipped with synchronized step-by-step engines 31 in order to keep the linear rate of the tape 12 constant during the activation of the surface treatment process. Friction devices incorporated in the reels 29, 30, not shown, limit the traction force of the tape 12 to pre-established values, correlated to the resistance of the ceramic substrate.

Furthermore, each chamber 13 comprises a guiding support 32 of the tape 12, comprising two parallel tracks, having a stepped seat, on which the tape runs resting on the two sides.

Each chamber has cooled walls 35 and cover 36 and comprises heating furnaces 37 to keep the internal temperature at a pre-established value, in the example, 700°C. The furnaces 37 shown in figures 1 to 3 are of the known irradiation type and comprise a set of halogen lamps having a length correlated to the duration of the treatment necessary in each chamber 13. Temperature control devices 38, or thermocouples, also control the thermal uniformity of the furnaces 37 for their whole length.

Each of the chambers 13 also comprises a gas inlet valve 39 and an air re-entering valve 40 for the opening of the chambers 13.

The pre-treatment chambers 13A and post-treatment chambers 13C are equipped with a primary pumping device 41, which can be common to that of the connection unit 14 connected to the respective chamber and connected to the chamber with an interception valve 43.

The treatment chamber 13B is equipped with a turbomolecular pump 42, or secondary pump, connected for supply to a primary pump 41.

The production in continuous plant of a superconducting tape 10, object of the present invention, must be equipped with a number of primary pumps 41 equal to the number of chambers 13 to avoid the mixing of different atmospheres.

On the bottom of the treatment chamber 13B, there is a coating device 44, for example a crucible, for the evaporation of the coating metal according to a technology of the known type. Alternatively to a thermal evaporation system, the deposition can be obtained with other known technologies, such as, for example, electronic bombardment. The deposition process must take place under high vacuum conditions, controlled by a vacuum gauge 45.

Each chamber 13 of the plant 10 according to the present invention can in any case be equipped with further instrumentation with respect to that described.

The surface treatment process of a tape substrate 12 for the production of a superconducting tape 12 is carried out in continuous in a closed plant 10 with respect to the outside environment.

The process comprises the following phases:
- unwinding the metallic tape 12 from the first reel 29 contained inside the pre-treatment chamber 13A, which is marked by pre-established pressure, atmosphere and temperature conditions;
- effecting a pre-treatment on the tape 12 while it passes through the pre-treatment chamber 13A by exposure to the conditions of the chamber itself;
- feeding the tape 12 through the first sealed connection unit 14AB to the treatment chamber 13B, which is marked by pre-established pressure, atmosphere and temperature conditions;
- treating a surface of the tape 12 by the deposition of oxide under the conditions of the treatment chamber 13B for a passage time;
- feeding the tape 12 through the second sealed connection unit 14BC to the post-treatment chamber 13C which is marked by pre-established pressure, atmosphere and temperature conditions;
- effecting a post-treatment on the tape 12 during its passage through the post-treatment chamber 13C by exposure to the conditions of the chamber itself;
- rewinding the treated tape 12 onto the second reel 30 contained inside the post-treatment chamber 13C.

The deposition of various layers of oxides on the surface of the metallic tape is effected by rewinding the tape 12, at the end of the first surface treatment process, onto the reel 29 in the pre-treatment chamber 13A and repeating the phases described above.

The plant for the production of a superconducting tape 10, object of the present invention and a relative surface treatment process have the advantage of producing, with a continuous process, multilayer coated products requiring various deposition phases and thermal treatment under different pressure and atmosphere conditions.

The solution, object of the present invention, allows a drastic cost reduction thanks to the possibility of effecting in situ and with a single passage, a complex deposition process of various thin layers with extremely different physico-chemical characteristics.

The possibility of depositing various layers in sequence without exposing the surface to the outside atmosphere also advantageously allows high-quality interfaces to be produced, eliminating or improving the adhesion properties and the lifetime of the product.

The plant thus conceived can undergo numerous modifications and variants, all included in the invention; furthermore, all the details can be substituted by technically equivalent elements. In practice, the materials used, as also the dimensions can vary according to technical demands.

## Claims

1. A plant for the production in continuous of a super-conducting tape comprising three vacuum chambers, i.e. a pre-treatment chamber (13A), a treatment chamber (13B) and a post-treatment chamber (13C), each marked by its own process conditions, i.e. pressure and gas atmosphere, said chambers (13A, 13B, 13C) being arranged in series and respectively connected with each other by a connection unit (14AB, 14BC), in which said connection unit (14AB, 14BC), which effects the continuous passage of a metallic tape (12), comprises at least one connection (27) with a primary pumping device, or rotary vane pump, (41), a first motorized reel (29) for the feeding of the tape (12) situated in said pre-treatment chamber (13A) and a second motorized winding reel (30) situated in said post-treatment chamber (13C), **characterized in that** said connection unit, suitable for allowing the continuous passage of a tape substrate (12) and obtaining sealed separation between said chambers (13), comprises a base (15) and a cover (18) seal coupled on complementary surfaces, wherein said base (15) comprises a longitudinal seat (19) in a central portion (17), for supporting and guiding said tape substrate (12), and **in that** it comprises, in correspondence with end portions (16), pass-through holes (21) for the passage of said tape substrate (12), wherein at least one connection (27) to a primary vacuum pumping device, or rotary vane pump (41), is situated along said central portion (17) and wherein said cover (18) is equipped with ends having the shape of a flute's mouthpiece, which are coupled with complementary tilting surfaces of the base (15).

2. The plant according to claim 1, **characterized in that** it comprises a primary pumping device, or rotary vane pump (41) for each of said pre-treatment (13A) and post-treatment (13C) chambers, said primary pumping device (41) also being connected to the respective connection unit (14AB, 14BC).

3. The plant according to claim 2, **characterized in that** said connection unit (14) comprises a second connection (28) to a secondary high vacuum pumping device, or turbomolecular pump (42), connected for supply to said primary pump (41).

4. The plant according to claim 2, **characterized in that** said treatment chamber (13B) comprises a secondary high vacuum pumping device, or turbomolecular pump (42), connected for supply to a specific primary pumping device (41).

5. The plant according to claim 1, **characterized in that** said first pre-treatment chamber (13A) comprises a gas inlet valve (39) for a reducing atmosphere consisting of a mixture of argon and hydrogen at a pressure of 10³ Pa, said second treatment chamber (13B) comprises a gas inlet valve (39) for a reducing atmosphere consisting of a mixture of argon, hydrogen and oxygen and a pressure of 10⁻² Pa, and a third post-treatment chamber (13C) comprises a gas inlet valve (39) for an oxidizing atmosphere consisting of oxygen and a pressure of 10³ Pa.

6. The plant according to claim 1, **characterized in that** said chambers (13A, 13B, 13C) comprise a supporting guide (32) of the tape (12) comprising two parallel tracks, each equipped with a stepped seat, wherein said seat of each track receives one side of said tape (12).

7. The plant according to claim 1, **characterized in that** each of said chambers (13A, 13B, 13C) has cooled walls (35) and cover (36) and comprises heating furnaces (37).

8. The plant according to claim 5, **characterized in that** each of said chambers (13A, 13B, 13C) comprises an air re-entering valve (40).

9. The plant according to claim 1, **characterized in that** said treatment chamber (13B) comprises a coating device (44) on the bottom, with thermal evaporation or electronic bombardment.

10. The plant according to claim 1, **characterized in that** a second connection (28) to a device for the secondary vacuum pumping device, or turbomolecular pump, (42), is situated along said central portion (17) of said connection unit (14AB, 14BC).

11. The plant according to claim 1, **characterized in that** said connection unit (14AB, 14BC) comprises a closed-ring groove (25) for the positioning of a sealing element (24) situated between said base (15) and said cover (18) on opposite sides of said longitudinal seat (19) and on said complementary tilting surfaces.

12. The plant according to claim 1, **characterized in that** said longitudinal seat (19) of said connection unit (14AB, 14BC) has a height greater than the thickness of said tape substrate (12) and comprises a central portion (20) with a greater grooving.

13. The plant according to claim 1, **characterized in that** said base (15) of said connection unit (14AB, 14BC) is a substantially semi-cylindrical body made of stainless steel and said cover (18) is a substantially semi-cylindrical body made of aluminum.

## Patentansprüche

1. Anlage zur kontinuierlichen Herstellung eines Supraleiterbandes, umfassend drei Vakuumkammern, d.h. eine Vorbehandlungskammer (13A), eine Behandlungskammer (13B) und eine Nachbehandlungskammer (13C), die jeweils durch ihre eigenen Prozessbedingungen, d.h. Druck und Gasatmosphäre, **gekennzeichnet** sind, wobei die Kammern (13A, 13B, 13C) in Reihe angeordnet und jeweils durch eine Verbindungseinheit (14AB, 14BC) miteinander verbunden sind, wobei die Verbindungseinheit (14AB, 14BC), die den kontinuierlichen Durchlauf eines Metallbands (12) bewirkt, mindestens eine Verbindung (27) mit einer primären Pumpvorrichtung oder Drehschieberpumpe (41), eine in der Vorbehandlungskammer (13A) befindliche erste angetriebene Haspel (29) zum Zuführen des Bands (12) und eine zweite in der Nachbehandlungskammer (13C) befindliche angetriebene Aufwickelhaspel (30) umfasst, **dadurch gekennzeichnet, dass** die Verbindungseinheit, die geeignet ist, den kontinuierlichen Durchlauf eines Bandsubstrats (12) zu ermöglichen und die dichte Trennung zwischen den besagten Kammern (13) zu erhalten, eine Basis (15) und eine Abdeckung (18) umfasst, die auf komplementären Oberflächen dicht verbunden sind, wobei die Basis (15) in einem mittleren Bereich (17) eine längslaufende Aufnahme (19) zum Tragen und Führen des Bandsubstrats (12) umfasst, und **dadurch**, dass sie auf Höhe von Endabschnitten (16) Durchgangslöcher (21) für den Durchgang des Bandsubstrats (12) umfasst, wobei mindestens eine Verbindung (27) mit einer primären Vakuumpumpvorrichtung oder Drehschieberpumpe (41) längs des mittleren Bereichs (17) angeordnet ist, und wobei die Abdeckung (18) mit Enden mit der Form eines Flötenmundstücks versehen ist, die mit komplementären Schrägflächen der Basis (15) verbunden sind.

2. Anlage nach Anspruch 1, **dadurch gekennzeichnet, dass** sie eine primäre Pumpvorrichtung oder Drehschieberpumpe (41) für jede Vorbehandlungskammer (13A) und Nachbehandlungskammer (13C) umfasst, wobei die primäre Pumpvorrichtung (41) auch mit der jeweiligen Verbindungseinheit (14AB, 14BC) verbunden ist.

3. Anlage nach Anspruch 2, **dadurch gekennzeichnet, dass** die Verbindungseinheit (14) eine zweite Verbindung (28) mit einer sekundären Hochvakuumpumpvorrichtung oder Turbomolekularpumpe (42) umfasst, die zur Versorgung mit der primären Pumpe (41) verbunden ist.

4. Anlage nach Anspruch 2, **dadurch gekennzeichnet, dass** die Behandlungskammer (13B) eine sekundäre Hochvakuumpumpvorrichtung oder Turbomolekularpumpe (42) umfasst, die zur Versorgung mit einer speziellen primären Pumpvorrichtung (41) verbunden ist.

5. Anlage nach Anspruch 1, **dadurch gekennzeichnet, dass** die erste Vorbehandlungskammer (13A) ein Gaseinlassventil (39) für eine aus einem Gemisch aus Argon und Wasserstoff bestehende reduzierende Atmosphäre mit einem Druck von 10³ Pa umfasst, die zweite Behandlungskammer (13B) ein Gaseinlassventil (39) für eine aus einem Gemisch aus Argon, Wasserstoff und Sauerstoff bestehende reduzierende Atmosphäre mit einem Druck von 10⁻² Pa umfasst und eine dritte Nachbehandlungskammer (13C) ein Gaseinlassventil (39) für eine aus Sauerstoff bestehende oxidierende Atmosphäre mit einem Druck von 10³ Pa umfasst.

6. Anlage nach Anspruch 1, **dadurch gekennzeichnet, dass** die Kammern (13A, 13B, 13C) eine Stützführung (32) für das Band (12) umfassen, die zwei parallele Bahnen umfasst, die beide mit einer abgestuften Aufnahme versehen sind, wobei die Aufnahme jeder Bahn eine Seite des Bands (12) aufnimmt.

7. Anlage nach Anspruch 1, **dadurch gekennzeichnet, dass** jede der Kammern (13A, 13B, 13C) Wände (35) und eine Abdeckung (36), die gekühlt sind, aufweist und Heizöfen (37) umfasst.

8. Anlage nach Anspruch 5, **dadurch gekennzeichnet, dass** jede der Kammern (13A, 13B, 13C) ein Ventil (40) zum Wiedereinlassen von Luft umfasst.

9. Anlage nach Anspruch 1, **dadurch gekennzeichnet, dass** die Behandlungskammer (13B) auf dem Boden eine Vorrichtung zum Beschichten (44) durch thermisches Verdampfen oder Elektronenbeschuss umfasst.

10. Anlage nach Anspruch 1, **dadurch gekennzeichnet, dass** eine zweite Verbindung (28) mit einer Vorrichtung für die sekundäre Vakuumpumpvorrichtung oder Turbomolekularpumpe (42) längs des mittleren Bereichs (17) der Verbindungseinheit (14AB, 14BC) angeordnet ist.

11. Anlage nach Anspruch 1, **dadurch gekennzeichnet, dass** die Verbindungseinheit (14AB, 14BC) eine einen geschlossenen Ring bildende Rille (25) zum Anordnen eines Dichtungselements (24) umfasst, das sich zwischen der Basis (15) und der Abdeckung (18) auf gegenüberliegenden Seiten der längslaufenden Aufnahme (19) und auf den komplementären Schrägflächen befindet.

12. Anlage nach Anspruch 1, **dadurch gekennzeichnet, dass** die längslaufende Aufnahme (19) der Verbindungseinheit (14AB, 14BC) eine Höhe aufweist, die größer als die Dicke des Bandsubstrats (12) ist, und einen mittleren Bereich (20) mit einer größeren Rillung umfasst.

13. Anlage nach Anspruch 1, **dadurch gekennzeichnet, dass** die Basis (15) der Verbindungseinheit (14AB, 14BC) ein aus rostfreiem Stahl bestehender im Wesentlichen halbzylindrischer Körper ist und die Abdeckung (18) ein im Wesentlichen halbzylindrischer Körper aus Aluminium ist.

## Revendications

1. Installation pour la production en continu d'une bande supraconductrice comprenant trois chambres à vide, précisément une chambre de prétraitement (13A), une chambre de traitement (13B) et une chambre de post-traitement (13C), chacune **caractérisée par** ses propres conditions de processus, c'est-à-dire pression et atmosphère de gaz, lesdites chambres (13A, 13B, 13C) étant agencées en série et respectivement connectées entre elles par une unité de connexion (14AB, 14BC), dans laquelle ladite unité de connexion (14AB, 14BC), qui effectue le passage continu d'une bande métallique (12), comprend au moins une connexion (27) avec un dispositif principal de pompage ou pompe à palettes rotatives (41) une première bobine motorisée (29) pour l'alimentation de la bande (12) située dans ladite chambre de prétraitement (13A) et une deuxième bobine motorisée d'enroulement (30) située dans ladite chambre de post-traitement (13C), **caractérisée en ce que** ladite unité de connexion, adaptée pour permettre le passage continu d'un substrat en bande (12) et obtenir la séparation étanche entre lesdites chambres (13), comprend une base (15) et un joint de couvercle (18) couplé sur des surfaces complémentaires, dans laquelle ladite base (15) comprend un siège longitudinal (19) dans une portion centrale (17), pour supporter et guider ledit substrat en bande (12), et **en ce qu'**elle comprend, en correspondance de portions d'extrémité (16), des trous traversants (21) pour le passage dudit substrat en bande (12), dans laquelle au moins une connexion (27) à un dispositif principal de pompage de vide ou pompe à palettes rotatives (41), est située le long de ladite portion centrale (17) et dans laquelle ledit couvercle (18) est équipé d'extrémités présentant la forme d'un bec de flûte, qui sont couplées avec des surfaces inclinées complémentaires de la base (15).

2. Installation selon la revendication 1, **caractérisée en ce qu'**elle comprend un dispositif principal de pompage ou pompe à palettes rotatives (41) pour chacune des chambres de prétraitement (13A) et de post-traitement (13C), ledit dispositif principal de pompage (41) étant également connecté à l'unité de connexion respective (14AB, 14BC).

3. Installation selon la revendication 2, **caractérisée en ce que** ladite unité de connexion (14) comprend une deuxième connexion (28) à un dispositif auxiliaire de pompage à vide poussé ou pompe turbo-moléculaire (42), connectée pour l'alimentation à ladite pompe principale (41).

4. Installation selon la revendication 2, **caractérisée en ce que** ladite chambre de traitement (13B) comprend un dispositif auxiliaire de pompage à vide poussé ou pompe turbo-moléculaire (42), connectée pour l'alimentation à un dispositif principal de pompage spécifique (41).

5. Installation selon la revendication 1, **caractérisée en ce que** ladite première chambre de prétraitement (13A) comprend une vanne d'entrée de gaz (39) pour une atmosphère réductrice composée d'un mélange d'argon et d'hydrogène à une pression de 10³ Pa, ladite deuxième chambre de traitement (13B) comprend une vanne d'entrée de gaz (39) pour une atmosphère réductrice composée d'un mélange d'argon, d'hydrogène et d'oxygène et une pression de 10⁻² Pa, et une troisième chambre de post-traitement (13C) comprend une vanne d'entrée de gaz (39) pour une atmosphère oxydante composée d'oxygène et une pression de 10³ Pa.

6. Installation selon la revendication 1, **caractérisée en ce que** lesdites chambres (13A, 13B, 13C) comprennent un guide de support (32) de la bande (12) comprenant deux voies parallèles, chacune équipée d'un siège à gradins, dans laquelle ledit siège de chaque voie reçoit un côté de ladite bande (12).

7. Installation selon la revendication 1, **caractérisée en ce que** chacune desdites chambres (13A, 13B, 13C) a des parois (35) et un couvercle (36) refroidis et comprend des fours de chauffage (37).

8. Installation selon la revendication 5, **caractérisée en ce que** chacune desdites chambres (13A, 13B, 13C) comprend une vanne de réintroduction d'air (40).

9. Installation selon la revendication 1, **caractérisée en ce que** ladite chambre de traitement (13B) comprend un dispositif de revêtement (44) sur le fond, avec évaporation thermique ou bombardement électronique.

10. Installation selon la revendication 1, **caractérisée en ce qu'**une deuxième connexion (28) à un dispositif pour le dispositif auxiliaire de pompage à vide ou pompe turbo-moléculaire (42) est située le long de ladite portion centrale (17) de ladite unité de connexion (14AB, 14BC).

11. Installation selon la revendication 1, **caractérisée en ce que** ladite unité de connexion (14AB, 14BC) comprend une rainure en anneau fermé (25) pour le positionnement d'un élément d'étanchéité (24) situé entre ladite base (15) et ledit couvercle (18) sur des côtés opposés dudit siège longitudinal (19) et sur des surfaces inclinées complémentaires.

12. Installation selon la revendication 1, **caractérisée en ce que** ledit siège longitudinal (19) de ladite unité de connexion (14AB, 14BC) a une hauteur supérieure à l'épaisseur dudit substrat en bande (12) et comprend une portion centrale (20) avec un rainurage supérieur.

13. Installation selon la revendication 1, **caractérisée en ce que** ladite base (15) de ladite unité de connexion (14AB, 14BC) est un corps sensiblement semi-cylindrique réalisé en acier inoxydable et ledit couvercle (18) est un corps sensiblement semi-cylindrique réalisé en aluminium.
